# EUROPEAN PATENT SPECIFICATION

(11) **EP 1 838 808 B1**
(45) Date of publication and mention of the grant of the patent: **15.06.2011**
(21) Application number: 06704497.4
(22) Date of filing: 06.01.2006
(51) Int. Cl.: C09K 11/77, C09K 11/78, C09K 11/79, C09K 11/80

(54) **ILLUMINATION SYSTEM COMPRISING CERAMIC LUMINESCENCE CONVERTER**
BELEUCHTUNGSSYSTEM MIT EINEM KERAMISCHEN LUMINESZENZUMWANDLER
SYSTEME D'ECLAIRAGE COMPRENANT UN CONVERTISSEUR DE LUMINESCENCE CERAMIQUE

(30) Priority: 10.01.2005 EP 05100093
(43) Date of publication of application: 03.10.2007
(73) Proprietor: Philips Intellectual Property & Standards GmbH, 20099 Hamburg (DE); Koninklijke Philips Electronics N.V., 5621 BA Eindhoven (NL)
(72) Inventor: SCHMIDT, Peter C/o Philips Intellectual, 52066 Aachen (DE); BUSSELT, Wolfgang C/o Philips Intellectual, 52066 Aachen (DE); GOLSCH, Silvia C/o Philips Intellectual, 52066 Aachen (DE)
(74) Representative: Bekkers, Joost J.J
(86) International application number: PCT/IB2006/050050
(87) International publication number: WO 2006/072918

(56) References cited:
- EP-A- 1 104 799
- US-A1- 2004 145 308
- US-A1- 2005 269 582

## Description

### BACKGROUND OF THE INVENTION

The present invention generally relates to an illumination system comprising a radiation source and a ceramic luminescence converter. The invention also relates to a ceramic luminescence converter for use in such illumination system.

More particularly, the invention relates to an illumination system and a ceramic luminescence converter for the generation of specific, colored light, including white light, by luminescent down conversion and additive color mixing based an a ultraviolet or blue radiation emitting radiation source. A light- emitting diode as a radiation source is especially contemplated.

Recently, various attempts have been made to make white light emitting illumination systems by using light emitting diodes as radiation sources. When generating white light with an arrangement of red, green and blue light emitting diodes, there has been such a problem that white light of the desired tone cannot be generated due to variations in the tone, luminance and other factors of the light emitting diodes.

In order to solve these problems, there have been previously developed various illumination systems, which convert the color of light emitting diodes by means of a luminescent material comprising a phosphor to provide a visible white light illumination.

Previous white light illumination systems have been based in particular on the dichromatic (BY) approach, mixing yellow and blue colors, in which case the yellow secondary component of the output light may be provided by a yellow phosphor and the blue component may be provided by a phosphor or by the primary emission of a blue LED.

In particular, the dichromatic approach as disclosed e.g. U.S. Patent 5,998,925 uses a blue light emitting diode of InGaN based semiconductor material combined with an Y₃Al₅O₁₂ :Ce (YAG-CE³⁺) phosphor powder. The YAG-Ce ³⁺phosphor powder is coated on the InGaN LED, and a portion of the blue light emitted from the LED is converted to yellow light by the phosphor. Another portion of the blue light from the LED is transmitted through the phosphor. Thus, this system emits both blue light, emitted from the LED, and yellow light emitted from the phosphor. The mixture of blue and yellow emission bands are perceived as white light by an observer with a typical CRI in the middle 70ties and a color temperature Tc, that ranges from about 6000 K to about 8000 K.

However, it has been a problem in prior art illumination systems comprising microcrystalline phosphor powders that they cannot be used for many applications due to their intransparency. Intransparency is caused by scattering of radiation by the microcrystalline phosphors.

DE 10349 038 discloses a light source, comprising at least one light emitting diode providing primary radiation and at least one polycrystalline luminescence converter comprising a phosphor for converting primary radiation into secondary radiation. Such polycrystalline luminescence converter provide for less light scattering and absorption. The phosphor may be cerium-doped yttrium aluminium garnet(YAG-Ce³⁺).

However, prior art solutions for illumination systems with an enhanced transparency had the drawback of an insufficient color rendition.

### BRIEF SUMMARY OF THE INVENTION

It is therefore an object to provide an illumination system for generating of white light, which has a suitable light extraction efficiency and transparency together with true color rendition.

According to another object of the invention an illumination system for generating of red to amber light is provided.

Thus the present invention provides an illumination system, comprising a radiation source and a monolithic ceramic luminescence converter comprising at least one phosphor capable of absorbing a part of light emitted by the radiation source and emitting light of wavelength different from that of the absorbed light; wherein said at least one phosphor is an europium(II) -activated oxonitridoaluminosilicate of general formula EA_{2-z}Si₅₋ₐAlₐN_{8-b}O_{b}:Eu_{z} wherein 0< a ≤ 4, 0< b ≤ 4 and 0 < z ≤ 0.2; EA is at least one earth alkaline metal chosen from the group of calcium, barium and strontium.

Preferably said radiation source is a light-emitting diode.

According to one embodiment of the invention said monolithic ceramic luminescence converter is a first luminescence converter element, further comprising one or more second luminescence converter elements.

The second luminescence converter element may be a coating, comprising a second phosphor. Otherwise the second luminescence converter element may be a second monolithic ceramic luminescence converter, comprising a second phosphor.

According to another aspect of the invention a monolithic ceramic illumination converter comprising at least one phosphor capable of absorbing a part of light emitted by the radiation source and emitting light of wavelength different from that of the absorbed light; wherein said at least one phosphor is an europium(II) - activated oxonitridoaluminosilicate of general formula EA_{2-z}Si₅₋ₐAlₐN_{8-b}O_{b}:Eu_{z} wherein 0< a ≤ 4, 0< b ≤ 4 and 0 < z ≤ 0.2; EA is at least one earth alkaline metal chosen from the group of calcium, barium and strontium, is provided.

Such converter is effective, as it is a good converter for high energy radiation, such as radiation in the UV to blue range of the electromagnetic spectrum. It is also effective, as it is a good transmitter of the light energy, that results from the conversion of the high energy radiation input. Otherwise the light would be absorbed in the material and the overall conversion efficiency suffers.

### DETAILED DESCRIPTION OF THE INVENTION

The present invention focuses on a monolithic ceramic luminescence converter comprising an europium(II)-activated oxonitridoaluminosilicate phosphor in any configuration of an illumination system comprising a source of primary radiation, including, but not limited to discharge lamps, fluorescent lamps, inorganic and organic light emitting diodes, laser diodes and X-ray tubes. As used herein, the term "radiation" encompasses radiation in the X-ray, UV, IR and visible regions of the electromagnetic spectrum.

While the use of the present monolithic ceramic luminescence converter is contemplated for a wide array of illumination, the present invention is described with particular reference to and finds particular application to illumination systems comprising light emitting diodes, especially UV- and blue-light-emitting diodes.

In general, a monolithic ceramic luminescence converter is a ceramic body, which emits electromagnetic radiation in the visible or near visible spectrum when stimulated by high energy electromagnetic photons.

A monolithic ceramic luminescence converter is characterized by its typical microstructure. The microstructure of a monolithic ceramic luminescence converter is polycrystalline, i.e. an irregular conglomerate of krypto-cristalline or nanocrystalline crystallites. Crystallites are grown to come in close contact and to share grain boundaries. Macroscopically the monolithic ceramic seems to be isotrope, though the polycrystalline microstructure may be easily detected by SEM (scanning electron microscopy).

Due to their polycrystalline microstructure ceramic luminescence converters are transparent or have at least high optical translucency with low light absorption.

The monolithic ceramic luminescence converter comprising an europium(II)-activated oxonitridoaluminosilicate phosphor of general formula EA_{2-z}Si₅₋ₐAlₐN_{8-b}O_{b}:Eu_{z} wherein 0< a ≤ 4, 0< b ≤ 4 and 0 < z ≤ 0.2; EA is at least one earth alkaline metal chosen from the group of calcium, barium and strontium has a high degree of physical integrity, which property render the material useful for machining and polishing to improve light extraction and enable light guiding effects.

The class of phosphor material used for the invention is based on europium(II)- activated luminescence of an oxygen- and aluminum-substituted nitridosilicate. The phosphor of general formula EA_{2-z}Si₅₋ₐAlₐN₈₋ₐOₐ:Eu_{z} wherein 0< a ≤ 2 and 0 < z ≤ 0.2; EA is at least one earth alkaline metal chosen from the group of calcium, barium and strontium comprises a host lattice, wherein the main components are silicon and nitrogen. The host lattice also comprises oxygen and aluminum. The host lattice is supposed to have a structure consisting of (N-Si-N-) and (O-Si/Al -N)-units in a three-dimensional network, wherein silicon is tetrahedrically surrounded by nitrogen and oxygen.

A series of compositions of general formula EA_{2-z}Si₅₋ₐAlₐN₈₋ₐOₐ:Eu_{z} can be manufactured, which form a complete solid solution for the range0< a ≤ 2 and 0 < z ≤ 0.2.and crystallise in the orthorhombic crystal system.

Table 1 discloses crystallographic data, CIE 1931 color coordinates and emission wavelength of compositions according to the formula (Sr_{1-x-y}Baₓ)₂Si₅₋ₐAlₐN₈. ₐOₐ:Eu_{y}.in comparison to prior art compositions (in italics).

| Composition | a [Å] | b [Å] | c [Å] | λₘₐₓ [nm] | x | y |
|---|---|---|---|---|---|---|
| Sr₂Si₃Al₂N₆O₂:Eu | 9.551 | 6.739 | 5.801 | 640 | 0.636 | 0.363 |
| *Sr₂Si₅N₈:Eu* | *9.341* | *6.821* | *5.711* | *620* | *0.616* | *0.383* |
| *Ba₂Si₅N₈:Eu* | *9.391* | *6.959* | *5.783* | *580* | *0.516* | *0.482* |

The incorporation of oxygen and aluminum in the host lattice increases the proportion of covalent bonding and ligand-field splitting. As a consequence this leads to a shift of excitation and emission bands to longer wavelengths in comparison to the basic nitridosilicate lattices.

Within the three dimensional network metal ions such as earth alkaline metals as well as europium(II) and eventually a co-activator are incorporated. Preferably the earth alkaline metals are selected from calcium, strontium and barium. The host lattice for those materials may be six element (two cation) oxonitridoaluminosilicate such as europium(II)-activated strontium oxonitridoaluminosilicate Sr₂Si₃Al₂N₆O₂:Eu for example, or may comprise more than six elements such as europium(II)-activated strontium-barium oxonitridoaluminosilicate (Sr,Ba)₂Si₃Al₂N₆O₂:Eu for example.

The proportion z of europium(II) is preferably in a range of 0.05< z < 0.2. When the proportion z of Eu(II) is lower, luminance decreases because the number of excited emission centers of photoluminescence due to europium(II)-cations decreases and, when the z is greater than 0.2, density quenching occurs. Density quenching refers to the decrease in emission intensity that occurs when the concentration of an activation agent added to increase the luminance of the fluorescent material is increased beyond an optimum level.

These europium(II)-activated oxonitridoaluminosilicate phosphors are responsive to more energetic portions of the electromagnetic spectrum than the visible portion of the spectrum.

In particular, the phosphors according to the invention are especially excitable by UV emission lines, which have such wavelengths as 200 to 420 nm, but are excited with higher efficiency by LED light emitted by a blue light-emitting component having a wavelength from 400 to 495 nm. Thus the fluorescent material of the monolithic ceramic luminescence converter has ideal characteristics for converting blue light of nitride semiconductor light emitting component into white or colored yellow, amber or red light.

The monolithic ceramic luminescence converter is manufactured by preparing in a first step a fluorescent microcrystalline phosphor powder material and in a second step isostatically pressing the microcrystalline material into pellets and sintering the pellets at an elevated temperature and for a period of time sufficient to allow compaction to an optically translucent body.

The method for producing a microcrystalline phosphor powder of the present invention is not particularly restricted, and it can be produced by any method, which will provide phosphors according to the invention.

A preferred process for producing a phosphor according to the invention is referred to as the solid-state method. In this process, the phosphor precursor materials are mixed in the solid state and are heated so that the precursors react and form a powder of the phosphor material.

In a specific embodiment these red to yellow-red emitting phosphors are prepared as phosphor powders by the following technique: To prepare the mixed oxides of the divalent metals high purity nitrates, carbonates, oxalates and acetates of the earth alkaline metals and europium(III) were dissolved with stirring in 25-30 ml deionized water. The solutions are stirred with heating on a hot-plate until the water has evaporated resulting in a white or yellow paste, depending on composition.

The solids are dried overnight (12 hours) at 120°C. The resulting solid is finely ground and placed into a high purity alumina crucible. The crucibles are loaded into a charcoal-containing basin and then into a tube furnace and purged with flowing nitrogen/hydrogen for several hours. The furnace parameters are 10 °C/min to 1600 °C, followed by a 4 hour dwell at 1300°C after which the furnace is turned off and allowed to cool to room temperature. These metal oxides are mixed with silicon nitride Si₃N₄ and aluminum nitride AlN in predetermined ratios.The mixture is placed into a high purity alumina crucible. The crucibles are loaded into a charcoal-containing basin and then into a tube furnace and purged with flowing nitrogen/hydrogen for several hours. The furnace parameters are 10 °C/min to 1600 °C, followed by a 4 hour dwell at 1600°C after which the furnace is slowly cooled to room temperature. The samples are once again finely ground before a second annealing step at 1600°C is performed. Luminous output may be improved through an additional third anneal at slightly lower temperatures in flowing argon.

Phosphor powder materials can also be made by liquid precipitation. In this method, a solution, which includes soluble phosphor precursors, is chemically treated to precipitate phosphor particles or phosphor particle precursors. These particles are typically calcined at an elevated temperature to produce the phosphor compound.

In yet another method, phosphor powder particle precursors or phosphor particles are dispersed in slurry, which is then spray dried to evaporate the liquid. The particles are thereafter sintered in the solid state at an elevated temperature to crystallize he powder and form a phosphor. The spray-dried powder is then converted to an oxide phosphor by sintering at an elevated temperature to crystallize the powder and to form the phosphor. The fired powder is then lightly crushed and milled to recover phosphor particles of desired particle size.

The fine-grained microcrystalline phosphor powders obtained by these methods are used to prepare a ceramic luminescence converter according to the invention. To this aim a suitable phosphor powder is subjected to a very high pressure either in combination with a treatment at elevated temperature or followed by a separate heat treatment. Isostatic pressing is preferred.

Especially preferred is a hot isostatic pressure treatment or otherwise cold isostatic pressure treatment followed by sintering. A combination of cold isostatic pressing and sintering followed by hot isostatic pressing may also be applied.

Careful supervision of the densification process is necessary to control grain growth and to remove residual pores.

Pressing and heat treatment of the phosphor material produces a monolithic ceramic body, which is easily sawed, machined and polished by current metallographic procedures. The polycrystalline ceramic material can be sawed into wafers, which are 1 millimetre or less in width. Preferably, the ceramic is polished to get a smooth surface and to impede diffuse scattering caused by surface roughness.

### Comparative embodiment

The following quantities of strontium carbonate and europium oxide were dry blended thoroughly:
SrCO₃: 20.0 g
Eu₂O₃: 0.487 g

The mixture was placed in an alumina crucible and was calcined at 1200°C for two hours in a reducing atmosphere that is a combination of 5% (by volume) hydrogen in nitrogen. After cooling down to room temperature, the obtained powder cake was crushed to a fine powder in a glove box under dry nitrogen gas.

The following quantities of the obtained mixed oxide powder and silicon nitride powder were wet mixed in dried acetone:
(Sr,Eu)O: 5.0 g
Si₃N₄: 3.77 g

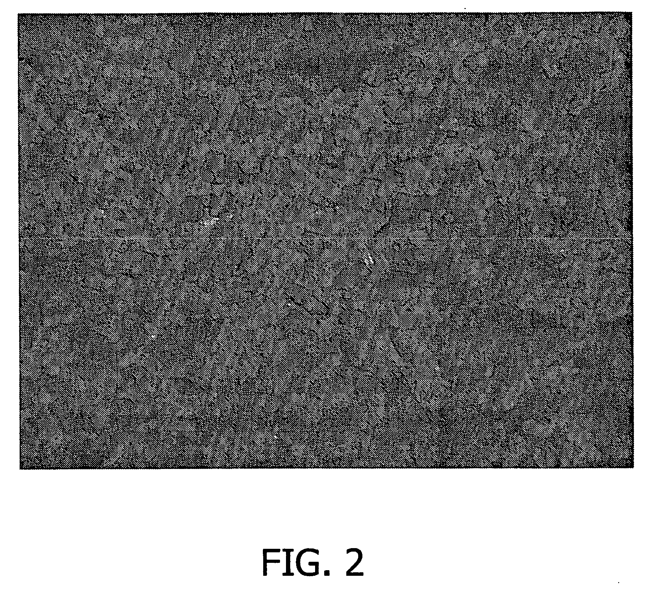

After drying of the powder mixture by evaporation of the acetone, it was placed in an alumina crucible and fired at 1550°C for two hours in a reducing atmosphere which is a combination of 5% (by volume) hydrogen in nitrogen. The raw phosphor powder was mixed with an organic glycol binder, pressed into pellets and further densified by cold isostatic pressing at 44800 Psi (3.091x 10⁸N/m²). The ceramic green bodies were then placed on a tungsten foil and fired at 1700°C for two hours in the same reducing atmosphere as described above. After cooling down to room temperature the nitride ceramics obtained were sawed into wavers. These wavers were grinded and polished to obtain the final translucent nitride ceramics. The CLC microstructure (Fig. 2) features a statistical granular structure of crystallites forming a grain boundary network at a magnification of 1000:1. The ceramics exhibit a density of 97% of the theoretical density of Sr₂Si₅N₈ (3.904 g/cm³). The density of the samples can further be improved by hot isostatic pressing of the ceramics in a nitrogen atmosphere (temperature range: 1600 - 1780°C, pressure range: 2000 to 30000 PSI (138.00 x 10⁵ to 2.070 x 10⁸ N/m²)) to remove remaining porosity.

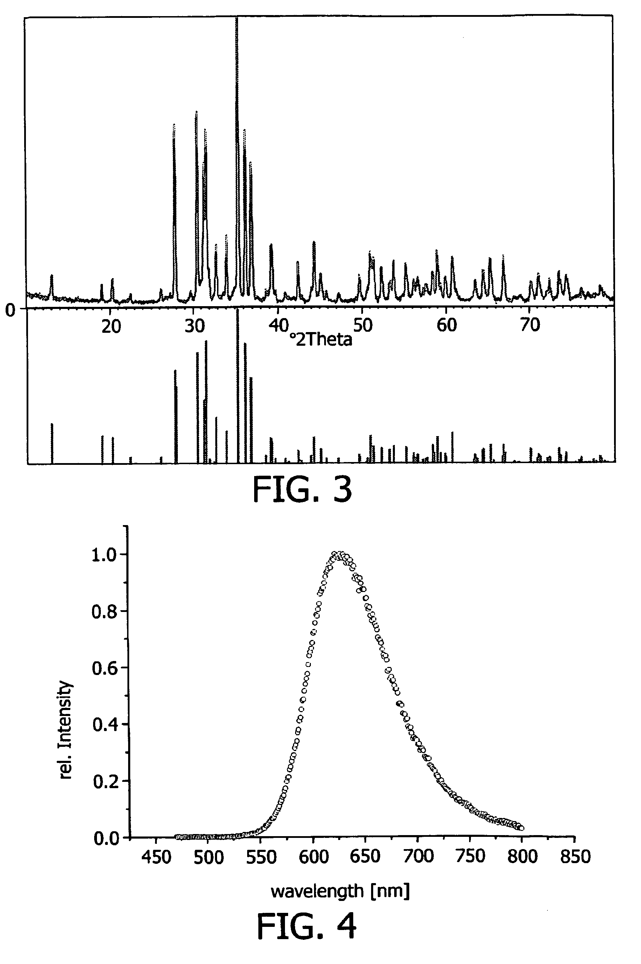

The phosphor ceramics were characterized by powder X-ray diffraction (Cu, Kα-line). Fig. 3 shows the X-ray diffraction data of the monolithic ceramic luminescence converter in comparison to a calculated XRD pattern based on the structural data for Sr₂Si₅N₈.

X-ray diffraction pattern as shown in Fig. 3 is consistent with the calculated XRD pattern of Sr₂Si₅N₈ with certain small deviations of position and intensity due to the substitution of europium for strontium.

The sintered phosphors were excited using a mercury lamp generating ultraviolet light having a peak wavelength of 365 nanometers. The photoluminescence of the phosphors was measured using a Minolta model CS- 100-A photometer.

Each phosphor of the europium(II)-activated oxonitridoaluminosilicate type emits a yellow, amber or deep red fluorescence when excited by radiation of the UVA or blue range of the electromagnetic spectrum.

When excited with radiation of wavelength 495 nm, these europium(II) activated oxonitridoaluminosilicate phosphor is found to give a broad band emission, which peak wave length at 640 nm and a tail emission up to 750 nm.

These europium-activated oxonitridoaluminosilicate phosphors can be excited efficiently with radiation of wavelength between 370 nm and 490 nm.

According to one aspect of the invention an illumination system, comprising a radiation source and a monolithic ceramic luminescence converter comprising at least one phosphor capable of absorbing a part of light emitted by the radiation source and emitting light of wavelength different from that of the absorbed light; wherein said at least one phosphor is an europium(II) -activated oxonitridoaluminosilicate of general formula EA_{2-z}Si₅₋ₐAlₐN_{8-b}O_{b}:Eu_{z} wherein 0< a ≤ 4, 0< b ≤ 4 and 0 < z ≤ 0.2; EA is at least one earth alkaline metal chosen from the group of calcium, barium and strontium is provided.

Radiation sources include preferably semiconductor optical radiation emitters and other devices that emit optical radiation in response to electrical excitation. Semiconductor optical radiation emitters include light emitting diode LED chips, light emitting polymers (LEPs), laser diodes (LDs), organic light emitting devices (OLEDs), polymer light emitting devices (PLEDs), etc.

Moreover, light emitting components such as those found in discharge lamps and fluorescent lamps, such as mercury low and high pressure discharge lamps, sulfur discharge lamps, and discharge lamps based an molecular radiators are also contemplated for use as radiation sources with the present inventive phosphor compositions.

In a preferred embodiment of the invention the radiation source is a light-emitting diode.

Any configuration of an illumination system which includes a light-emitting diode or an array of light-emitting diodes and ceramic luminescence converter comprising a europium(II) activated oxonitridoaluminosilicate phosphor composition is contemplated in the present invention, preferably with addition of other well-known phosphors, which can be combined to achieve a specific color or white light when irradiated by a LED emitting primary UV or blue light as specified above.

Possible configurations useful to couple the monolithic ceramic luminescence converter to a light emitting diode or an array of light emitting diodes comprise leadframe-mounted LEDs as well as surface-mounted LEDS.

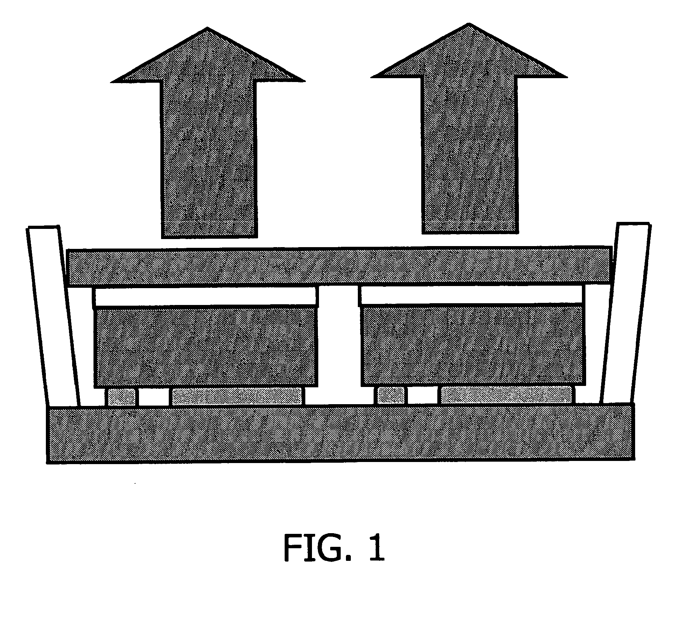

A detailed construction of one embodiment of such illumination system comprising a radiation source and a monolithic ceramic luminescence converter shown in Fig.1 will now be described.

FIG. 1 shows a schematic view of a flip chip type light emitting diode with ceramic a luminescence converter.

The light emitting diode is surface-mounted on a substrate. The monolithic ceramic luminescence converter is configured as a plate, that is positioned in that way, that most of the light, which is emitted from the light-emitting diode, enters the plate in an angle, which is somewhat perpendicular to the surface of the plate. To achieve this, a reflector is provided around the light-emitting diode in order to reflect light that is emitted from the light-emitting diode in directions untowardly the plate.

In operation, electrical power is supplied to the dice to activate the dice. When activated, the dice emits the primary light, e.g. blue light. A portion of the emitted primary light is completely or partially absorbed by the ceramic luminescence converter. The ceramic luminescence converter then emits secondary light, i.e., the converted light having a longer peak wavelength, primarily yellow in a sufficiently broadband (specifically with a significant proportion of red) in response to absorption of the primary light. The remaining unabsorbed portion of the emitted primary light is transmitted through the ceramic luminescence converter, along with the secondary light.

The reflector directs the unabsorbed primary light and the secondary light in a general direction as output light. Thus, the output light is a composite light that is composed of the primary light emitted from the die and the secondary light emitted from the fluorescent layer.

The color temperature or color point of the output light of an illumination system according to the invention will vary depending upon the spectral distributions and intensities of the secondary light in comparison to the primary light.

Firstly, the color temperature or color point of the primary light can be varied by a suitable choice of the light emitting diode.

Secondly, the color temperature or color point of the secondary light can be varied by a suitable choice of the phosphor composition in the ceramic luminescence converter.

Furthermore, these arrangements also advantageously afford the possibility of using a second luminescence converter, as a result of which, advantageously, the desired hue can be set even more accurately.

According to one aspect of the invention the output light of the illumination system may have a spectral distribution such that it appears to be "white" light.

In a first embodiment of a white-light emitting illumination system according to the invention the device can advantageously be produced by choosing the luminescent material such that a blue radiation emitted by a blue light emitting diode is converted into complementary wavelength ranges, to form dichromatic white light.

In this case, yellow light is produced by means of the phosphor material of the monolithic ceramic luminescence converter, that comprises a phosphor of general formula EA_{2-z}Si₅₋ₐAlₐN_{8-b}O_{b}:Eu_{z} wherein 0< a ≤ 4, 0< b ≤ 4 and 0 < z ≤ 0.2; EA is at least one earth alkaline metal chosen from the group of calcium, barium and strontium.

Also a second red fluorescent material can be used, in addition, in order to improve the color rendition of this illumination system further.

Particularly good results are achieved with a blue LED whose emission maximum lies at 380 to 480 nm. An optimum has been found to lie at 445 to 468 nm, taking particular account of the excitation spectrum of the europium(II)-activated oxonitridoaluminosilicate.

A white-light emitting illumination system according to the invention can particularly preferably be realized by mounting a polished ceramic luminescence converter according to the invention with dimensions of 4 x 4 x 0.3 mm on an 1 W (Al,In,Ga)N LED chip emitting at 458 nm.

Part of a blue radiation emitted by a 458 nm Al,In,Ga)N light emitting diode is shifted by the europium(II)-activated oxonitridoaluminosilicate into the orange to red spectral region and, consequently, into a wavelength range which is complementarily colored with respect to the color blue. A human observer perceives the combination of blue primary light and the secondary light of the orange-emitting phosphor as white light.

When compared with the spectral distribution of the white output light generated by the prior art illumination system comprising YAG:Ce as a ceramic luminescence converter the apparent difference in the spectral distribution is the shift of the peak wavelength which is in the red region of the visible spectrum. Thus, the white output light generated by the illumination system has a significant additional amount of red color, as compared to the output light generated by the prior art.

In a second embodiment, a white-light emitting illumination system according to the invention can advantageously be produced by choosing the luminescent material such that a blue radiation emitted by the blue light emitting diode is converted into complementary wavelength ranges, to form polychromatic white light. In this case, orange to red light is produced by means of the luminescent materials, that comprise a blend of phosphors including europium(II)-activated oxonitridoaluminosilicate phosphor as a first monolithic ceramic luminescence converter and a second phosphor in a second luminescence converter.

The second luminescence converter may be provided as a second monolithic ceramic luminescence converter or as a conventional phosphor coating.

Useful second phosphors and their optical properties are summarized in the following table 2:

| Composition | λₘₐₓ [nm] | Color point x, y |
|---|---|---|
| (Ba₁₋ₓSrₓ)₂SiO₄:Eu | 523 | 0.272, 0.640 |
| SrGa₂S₄:Eu | 535 | 0.270, 0.686 |
| SrSi₂N₂O₂:Eu | 541 | 0.356, 0.606 |
| SrS:Eu | 610 | 0.627, 0.372 |
| (Sr_{1-x-y}CaₓBa_{y})₂Si₅N₈:Eu | 615 | 0.615,0.384 |
| (Sr_{1-x-y}CaₓBa_{y})₂Si₅₋ₓAlₓN₈₋ₓOₓ:Eu | 615-650 | * |
| CaS:Eu | 655 | 0.700,0.303 |
| (Sr₁₋ₓCaₓ)S:Eu | 610-655 | * |

According to further aspect of the invention an illumination system that emits output light having a spectral distribution such that it appears to be "yellow to red" light is provided

A monolithic ceramic luminescence converter comprising europium(II) - activated oxonitridoaluminosilicate of general formula EA_{2-z}Si₅₋ₐAlₐN_{8-b}O_{b}:Eu_{z} wherein 0< a ≤ 4, 0< b ≤ 4 and 0 < z ≤ 0.2; EA is at least one earth alkaline metal chosen from the group of calcium, barium and strontium as phosphor is particularly well suited as a yellow component for stimulation by a primary UVA or blue radiation source such as, for example, an UVA-emitting LED or blue-emitting LED.

It is possible thereby to implement an illumination system emitting in the yellow to red regions of the electromagnetic spectrum.

A yellow-light emitting illumination system according to the invention can advantageously be produced by choosing the luminescent material such that a blue radiation emitted by the blue light emitting diode is converted into complementary wavelength ranges, to form dichromatic yellow light.

In this case, yellow light is produced by means of the luminescent materials, that comprise a ytterbium-activated oxonitridosilicate phosphor.

Particularly good results are achieved with a blue LED whose emission maximum lies at 400 to 480 nm. An optimum has been found to lie at 445 to 465 nm, taking particular account of the excitation spectrum of the halogen-oxonitridosilicate.

FIG 4 shows the emission spectra of a monolithic ceramic luminescence converter comprising an europium(II) -activated oxonitridoaluminosilicate of general formula EA_{2-z}Si₅₋ₐAlₐN_{8-b}O_{b}:Eu, wherein 0< a ≤ 4, 0< b ≤ 4 and 0< z ≤ 0.2; EA is at least one earth alkaline metal chosen from the group of calcium, barium and strontium

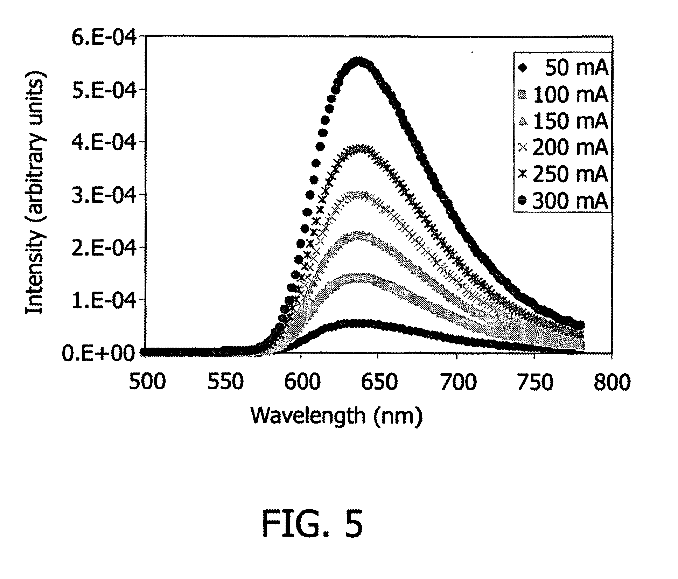

FIG 5 shows the emission spectra of a monolithic ceramic luminescence converter comprising an europium(II) -activated oxonitridoaluminosilicate of general formula EA_{2-z}Si₅₋ₐAlₐN_{8-b}O_{b}:Eu_{z} wherein 0< a ≤ 4, 0< b ≤ 4 and 0< z ≤ 0.2; EA is at least one earth alkaline metal chosen from the group of calcium, barium and strontium in combination with a blue light emitting diode for various drive currents 50 to 300 mA. The color point of the system is independent from the forward current. The associated color point is x= 0.675, y = 0.317.

The color output of the LED - phosphor system is very sensitive to the thickness of the phosphor layer, if the phosphor layer is thick and comprises an excess of a yellow ytterbium activated oxonitridosilicate phosphor, then a lesser amount of the blue LED light will penetrate through the thick phosphor layer. The combined LED - phosphor system will then appear yellow to red, because it is dominated by the yellow to red secondary light of the phosphor. Therefore, the thickness of the phosphor layer is a critical variable affecting the color output of the system.

The hue (color point in the CIE chromaticity diagram) of the yellow light thereby produced can in this case be varied by a suitable choice of the phosphor in respect of mixture and concentration.

In another embodiment, a yellow to red-light emitting illumination system according to the invention can advantageously be produced by choosing radiation source such that a UV radiation emitted by the UV emitting diode is converted entirely into monochromatic yellow to red light by a monolithic ceramic luminescence converter according to the invention.

### BRIEF DESCRIPTION OF THE DRAWINGS

FIG. 1 shows a schematic side view of a dichromatic white LED lamp comprising a ceramic luminescence converter of the present invention positioned in the pathway of light emitted by an light-emitting diode flip chip structure.
Fig. 2 shows the microstructure of an etched ceramic luminescence converter, magnification 1000:1.
Fig. 3A shows a XRD pattern of ceramic luminescence converter according to the invention measured by Cu Kα radiation.
Fig. 3B shows a calculated XRD pattern of Sr₂Si₅N₈.
Fig. 4 shows the emission spectrum of a ceramic luminescence converter according to the invention (λ _{exc}=450 nm).
Fig. 5 shows a) the emission spectra for various drive currents from 50 to 300 mA and b) the output characteristics of a red 638 nm CLC illumination system.

## Claims

1. Illumination system, comprising a radiation source and a monolithic ceramic luminescence converter comprising at least one phosphor capable of absorbing a part of light emitted by the radiation source and emitting light of wavelength different from that of the absorbed light; wherein said at least one phosphor is an europium(II) - activated oxonitridoaluminosilicate of general formula EA_{2-z}Si₅₋ₐAlₐN_{8-b}O_{b}:Eu_{z} wherein 0< a ≤ 4, 0< b ≤ 4 and 0 < z ≤ 0.2; EA is at least one earth alkaline metal chosen from the group of calcium, barium and strontium.

2. Illumination system according to claim 1, wherein said radiation source is a light-emitting diode.

3. Illumination system according to claim 1, wherein said monolithic ceramic luminescence converter is a first luminescence converter element, further comprising one or more second luminescence converter elements.

4. Illumination system according to claim 3, wherein the second luminescence converter element is a coating, comprising a phosphor.

5. Illumination system according to claim 3, wherein the second luminescence converter element is a second monolithic ceramic luminescence converter, comprising a second phosphor.

6. Monolithic ceramic luminescence converter comprising at least one phosphor capable of absorbing a part of light emitted by the radiation source and emitting light of wavelength different from that of the absorbed light; wherein said at least one phosphor is an europium(II) -activated oxonitridoaluminosilicate of general formula EA_{2-z}Si₅₋ₐAlₐN_{8-b}O_{b}:Eu_{z} wherein 0< a ≤ 4, 0< b ≤ 4 and 0 < z ≤ 0.2; EA is at least one earth alkaline metal chosen from the group of calcium, barium and strontium.

## Patentansprüche

1. Beleuchtungssystem mit einer Strahlungsquelle und einem monolithischen, keramischen Lumineszenzkonverter, der mindestens einen Leuchtstoff umfasst, der imstande ist, einen Teil des von der Strahlungsquelle emittierten Lichts zu absorbieren und Licht mit einer anderen Wellenlänge als dieser des absorbierten Lichts zu emittieren, wobei der mindestens eine Leuchtstoff ein Europium(II)-aktiviertes Oxonitridoaluminosilicat der allgemeinen Formel EA_{2-z}Si₅₋ₐAlₐN_{8-b}O_{b}:Eu_{z} ist, wobei 0 < a ≤ 4, 0 < b ≤ 4 und 0< z ≤ 0,2, und wobei EA mindestens ein Erdalkalimetall ist, das aus der Gruppe aus Calcium, Barium und Strontium ausgewählt wird.

2. Beleuchtungssystem nach Anspruch 1, wobei es sich bei der Strahlungsquelle um eine Licht emittierende Diode handelt.

3. Beleuchtungssystem nach Anspruch 1, wobei der monolithische, keramische Lumineszenzkonverter durch ein erstes Lumineszenzkonverterelement dargestellt ist, wobei dieser weiterhin ein oder mehrere zweite Lumineszenzkonverterelemente umfasst.

4. Beleuchtungssystem nach Anspruch 3, wobei das zweite Lumineszenzkonverterelement eine Beschichtung ist, die einen Leuchtstoff enthält.

5. Beleuchtungssystem nach Anspruch 3, wobei das zweite Lumineszenzkonverterelement durch einen zweiten monolithischen, keramischen Lumineszenzkonverter dargestellt ist, der einen zweiten Leuchtstoff enthält.

6. Monolithischer, keramischer Lumineszenzkonverter, der mindestens einen Leuchtstoff umfasst, der imstande ist, einen Teil des von der Strahlungsquelle emittierten Lichts zu absorbieren und Licht mit einer anderen Wellenlänge als dieser des absorbierten Lichts zu emittieren, wobei der mindestens eine Leuchtstoff ein Europium(II)-aktiviertes Oxonitridoaluminosilicat der allgemeinen Formel EA_{2-z}Si₅₋ₐAlₐN_{8-b}O_{b}:Eu_{z} ist, wobei 0 < a ≤ 4, 0 < b ≤ 4 und 0< z ≤ 0,2, und wobei EA mindestens ein Erdalkalimetall ist, das aus der Gruppe aus Calcium, Barium und Strontium ausgewählt wird.

## Revendications

1. Système d'éclairage, comprenant une source de rayonnement et un convertisseur de luminescence en céramique monolithique comprenant au moins un phosphore capable d'absorber une partie de la lumière émise par la source de rayonnement et émettant une lumière de longueur d'onde différente de celle de la lumière absorbée ; dans lequel ledit au moins un phosphore est un oxonitridoaluminosilicate activé par europium(II) de formule générale EA_{2-z}Si₅₋ₐAlₐN_{8-b}O_{b}:Eu_{z} dans lequel 0 < a ≤ 4, 0 < b ≤ 4 et 0 < z ≤ 0,2 ; EA est au moins un métal alcalin terreux choisi dans le groupe se composant de calcium, baryum et strontium.

2. Système d'éclairage selon la revendication 1, dans lequel ladite source de rayonnement est une diode électroluminescente.

3. Système d'éclairage selon la revendication 1, dans lequel ledit convertisseur de luminescence en céramique monolithique est un premier élément convertisseur de luminescence, comprenant en outre un ou plusieurs deuxièmes éléments convertisseurs de luminescence.

4. Système d'éclairage selon la revendication 3, dans lequel le deuxième élément convertisseur de luminescence est un revêtement, comprenant un phosphore.

5. Système d'éclairage selon la revendication 3, dans lequel le deuxième élément convertisseur de luminescence est un deuxième convertisseur de luminescence en céramique monolithique, comprenant un deuxième phosphore.

6. Convertisseur de luminescence en céramique monolithique comprenant au moins un phosphore capable d'absorber une partie de la lumière émise par la source de rayonnement et émettant une lumière de longueur d'onde différente de celle de la lumière absorbée ; dans lequel ledit au moins un phosphore est un oxonitridoaluminosilicate activé par europium(II) de formule générale EA_{2-z}Si₅₋ₐAlₐN_{8-b}O_{b}:Eu_{z} dans lequel 0 < a ≤ 4, 0 < b ≤ 4 et 0 < z ≤ 0,2 ; EA est au moins un métal alcalin terreux choisi dans le groupe se composant de calcium, baryum et strontium.
